(19) **Europäisches Patentamt European Patent Office Office européen des brevets**

(11) **EP 4 079 680 B1**

(12) **FASCICULE DE BREVET EUROPEEN**

(45) Date de publication et mention de la délivrance du brevet:
**08.11.2023 Bulletin 2023/45**

(21) Numéro de dépôt: **22168717.1**

(22) Date de dépôt: **19.04.2022**

(51) Classification Internationale des Brevets (IPC):
**B82Y 10/00** (2011.01)    **G06N 10/40** (2022.01)

(52) Classification Coopérative des Brevets (CPC):
**G06N 10/40; B82Y 10/00; G06N 10/00**

(54) **DISPOSITIF DE CONVERSION ÉLECTROMÉCANIQUE ET SYSTÈME UTILISANT UN TEL DISPOSITIF**

VORRICHTUNG ZUR ELEKTROMECHANISCHEN UMWANDLUNG UND SYSTEM, DAS EINE SOLCHE VORRICHTUNG VERWENDET

ELECTROMECHANICAL CONVERSION DEVICE AND SYSTEM USING SUCH A DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.04.2021 FR 2104084**

(43) Date de publication de la demande:
**26.10.2022 Bulletin 2022/43**

(73) Titulaires:
• **Commissariat à l'Energie Atomique et aux Energies Alternatives**
**75015 Paris (FR)**
• **Centre national de la recherche scientifique**
**75016 Paris (FR)**

(72) Inventeurs:
• **JOURDAN, Guillaume**
**38054 GRENOBLE CEDEX 09 (FR)**
• **HENTZ, Sébastien**
**38054 GRENOBLE CEDEX 09 (FR)**
• **LADNER, Carine**
**38054 GRENOBLE CEDEX 09 (FR)**
• **RAFSANJANI AMIN, Kazi**
**38054 GRENOBLE CEDEX 09 (FR)**
• **RENARD, Julien**
**38170 SEYSSINET-PARISET (FR)**
• **ROCH, Nicolas**
**38042 GRENOBLE CEDEX 09 (FR)**

(74) Mandataire: **Cabinet Camus Lebkiri**
**25 rue de Maubeuge**
**75009 Paris (FR)**

(56) Documents cités:
**US-B1- 9 454 061**

• **MAHMOUD KALAEE ET AL: "Quantum electromechanics of a hypersonic crystal", ARXIV.ORG, CORNELL UNIVERSITY LIBRARY, 201 OLIN LIBRARY CORNELL UNIVERSITY ITHACA, NY 14853, 14 août 2018 (2018-08-14), XP081179905, DOI: 10.1038/S41565-019-0377-2**
• **FINK J M ET AL: "Efficient microwave frequency conversion mediated by the vibrational motion of a silicon nitride nanobeam oscillator", ARXIV.ORG, CORNELL UNIVERSITY LIBRARY, 201 OLIN LIBRARY CORNELL UNIVERSITY ITHACA, NY 14853, 27 novembre 2019 (2019-11-27), XP081541249,**
• **ARNOLD G ET AL: "Converting microwave and telecom photons with a silicon photonic nanomechanical interface", NATURE COMMOUNICATIONS,, vol. 11, 1 janvier 2020 (2020-01-01), XP002804874,**
• **RODRIGUES I C ET AL: "Coupling microwave photons to a mechanical resonator using quantum interference", ARXIV.ORG, CORNELL UNIVERSITY LIBRARY, 201 OLIN LIBRARY CORNELL UNIVERSITY ITHACA, NY 14853, 2 juillet 2019 (2019-07-02), XP081388678,**
• **NICHOLAS J LAMBERT ET AL: "Coherent conversion between microwave and optical photons -- an overview of physical implementations", ARXIV.ORG, CORNELL UNIVERSITY LIBRARY, 201 OLIN LIBRARY CORNELL UNIVERSITY ITHACA, NY 14853, 25 juin 2019 (2019-06-25), XP081383855,**

## Description

### DOMAINE TECHNIQUE

Le domaine technique est celui des dispositifs quantiques.

La présente invention concerne un dispositif de conversion électromécanique et en particulier un dispositif de conversion électromécanique comprenant un circuit électrique résonnant comportant une inductance ainsi qu'un condensateur, le condensateur ayant au moins une première électrode et une deuxième électrode dont l'une est située sur une face d'une micropoutrelle, de sorte que la capacité électrique du condensateur varie lorsque la micropoutrelle oscille.

### ARRIERE-PLAN TECHNOLOGIQUE

Dans le cadre de l'informatique quantique, il peut s'avérer nécessaire d'adresser, de manière cohérente, différents systèmes physiques (on parle en général de systèmes hybrides) sur une large gamme de fréquences (par exemple, du domaine des micro-ondes à celui des photons optiques ou infrarouges). Un moyen de réaliser un tel adressage est d'utiliser des résonateurs mécaniques dans le régime quantique. De tels résonateurs peuvent par exemple être couplés avec un qubit pour assurer son adressage, convertir de manière cohérente des photons infrarouges en micro-ondes ou bien encore stocker l'état d'un photon. Il s'agit bien entendu d'une liste non exhaustive.

La conversion de photons infrarouges en photons micro-ondes (et vice-versa) présente un intérêt tout particulier. En effet, s'agissant des systèmes de calcul quantique, de nombreuses réalisations actuelles (par exemple basées sur des Q-bits supraconducteurs) mettent en oeuvre des phénomènes et mécanismes dont les fréquences typiques sont de l'ordre du Gigahertz. Tandis que pour des échanges à longue distance, une communication optique (via des fibres optiques par exemple) est l'une des solutions les plus adaptées. Pouvoir interfacer un système fonctionnant dans la gamme des Gigahertz avec un réseau de communication optique serait donc particulièrement intéressant. Pour cela, on connait un système comprenant un résonateur mécanique couplé d'une part à un résonateur micro-onde et d'autre part à un résonateur optique. Un tel système peut notamment être mis en oeuvre pour le calcul quantique distribué, les communications sécurisées par des protocoles quantiques ou bien encore la métrologie quantique. Il permet en particulier de répondre à un besoin technologique de taille : comment transférer l'information quantique sur de longues distances à température ambiante.

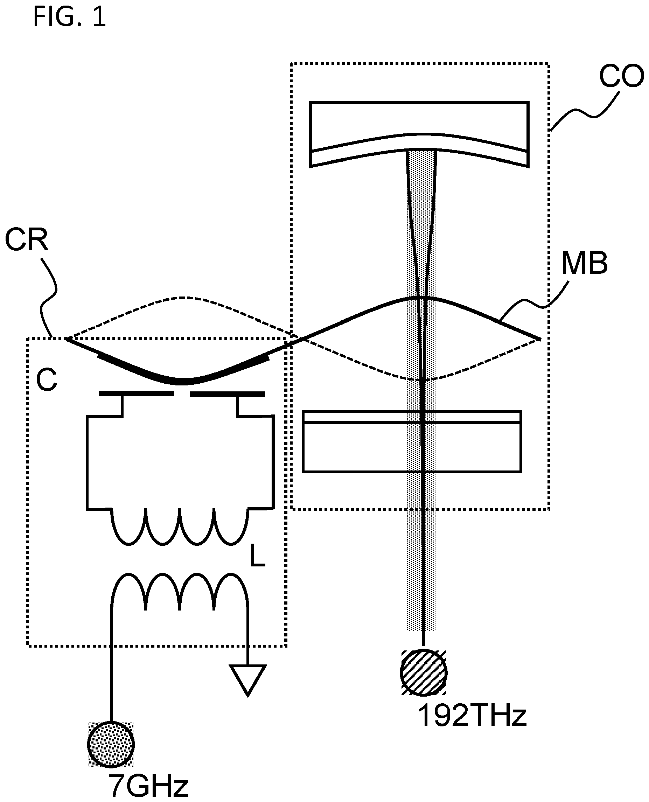

Un schéma d'un tel système est illustré à la [Fig. 1]. Le système comprend un circuit résonant CR comportant une inductance L et une capacité C dont l'une des électrodes est susceptible de vibrer. Le condensateur est également relié par le biais de l'inductance à un premier dispositif quantique opérant dans le domaine du GHz (dans cet exemple, aux alentours de 7 GHz). Ainsi, l'état de ce premier dispositif quantique est couplé aux vibrations de l'électrode du condensateur C. Le système comprend également une cavité optique CO dans laquelle est placée une membrane MB susceptible de vibrer. La vibration de cette membrane MB est couplée, à l'aide d'un laser et de la cavité optique CO, à un deuxième dispositif quantique opérant dans le domaine de la centaine de THz (dans cet exemple, aux alentours de 192THz). Ainsi, l'état de ce deuxième dispositif quantique est couplé aux vibrations de la membrane MB. En outre, la membrane MB est couplée mécaniquement à l'électrode du condensateur C susceptible de vibrer. Dans certaines conditions qui vont être détaillées maintenant, il est possible à l'aide de ce système de coupler le premier dispositif quantique au deuxième dispositif quantique.

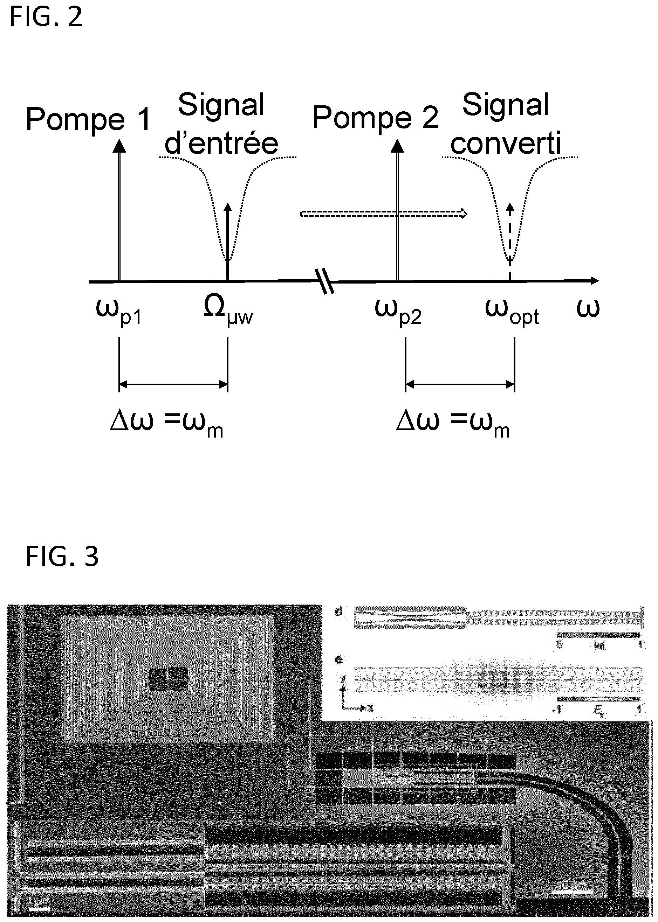

Le principe général d'une telle conversion est illustré à la [Fig. 2]. Sur la gauche se trouve la partie du système opérant dans le domaine des GHz à la fréquence $\omega_{\mu w}$. Sur la droite se trouve la partie du système opérant dans le domaine de la centaine de THz, à la fréquence $\omega_{opt}$. Afin de pouvoir coupler ces deux parties, on peut injecter dans la première partie du système un premier signal pompe à la fréquence $\omega_{p1}$ et dans la deuxième partie du système un deuxième signal pompe à la fréquence $\omega_{p2}$. Ces deux fréquences ne peuvent cependant pas être choisies arbitrairement, mais de sorte à vérifier la relation suivante :

[Math. 1]

$$\omega_{\mu w} - \omega_{p1} = \omega_{opt} - \omega_{p2} = \omega_m$$

Lorsqu'une telle relation est vérifiée, alors il est possible de créer de manière cohérente un photon à la fréquence à $\omega_{opt}$ à partir d'un photon à la fréquence $\omega_{\mu w}$, la médiation se faisant par le biais d'un phonon à la fréquence $\omega_m$, et donc transférer l'information quantique du premier dispositif au deuxième dispositif.

Afin de réaliser une telle conversation avec un dispositif intégrable, plus compact que celui de la [Fig. 1], il a été proposé d'adopter un circuit tel que décrit dans le document « Converting microwave and telecom photons with a silicon photonic nanomechanical interface » par G. Arnold et al. , Nature Com. 11, Article number: 4460 (2020) et illustrée à la [Fig. 3] (qui correspond à la figure 1 du document en question). Dans ce document, afin de pouvoir obtenir un circuit résonant CR micro-ondes ayant une fréquence de résonance dans le domaine du GHz, comme la capacité du condensateur est faible (de l'ordre du femtofarad), une inductance assez élevée, de l'ordre de la centaine de nanohenry ou plus, est souhaitable. Pour obtenir une inductance suffisamment élevée, les auteurs de ce document proposent de réaliser cette inductance à l'aide d'une piste électrique enroulée sur elle-même, clairement visible sur la [Fig. 3]. Bien qu'une telle structure permette une conversion telle que décrite précédemment, le rendement obtenu n'est pas élevé.

En effet, de manière générale, tous les photons ne sont pas convertis d'un domaine de fréquence à l'autre. Il est possible de définir un rendement de conversion noté $\eta_c$ qui permet de caractériser le taux de conversation. Il est possible de montrer que ce rendement est proportionnel à quatre grandeurs : le facteur de couplage optique de la cavité optique noté $g_{opt}^2$ , le nombre de photons de la pompe optique noté $n_{opt}$, le facteur de couplage électromécanique noté $g_{em}^2$ , et le nombre de photons de la pompe micro-onde noté $n_{MW}$. Dans la suite, l'invention visant à améliorer la conversation électromécanique, c'est au facteur de couplage électromécanique que l'on s'intéressera. Ce dernier est donné par l'équation suivante :

[Math 2]

$$g_{em} = \eta \frac{\omega_{\mu w}}{2} \frac{1}{C_g} \frac{\partial C_g}{\partial a} \text{ avec } \eta = \frac{C_g}{C_{tot}}$$

Où $\omega_{\mu w}$ est la fréquence de résonance du circuit micro-onde, $C_g$ est la capacité du condensateur variable (mobile), couplé au résonateur mécanique, et dont au moins l'une des électrodes vibre, $C_{tot}$ est la capacité totale du circuit micro-onde (somme de la capacité $C_g$ et de capacités parasites qui ne varient pas lorsque le résonnateur mécanique vibre), et $a$ est la distance séparant les deux électrodes (i.e. : les deux armatures) du condensateur C. Comme le montre cette expression, afin de maximiser ce couplage, il est important de s'assurer que la capacité $C_g$ du condensateur variable, couplé au résonateur mécanique, soit proche de la capacité totale $C_{tot}$. Autrement dit, il convient de réduire au maximum les capacités parasites (non couplées à la vibration mécanique), dans le circuit résonant.

Or, dans le circuit de la [Fig. 3], une partie non négligeable de la capacité totale $C_{tot}$ du circuit résonant n'est pas due au condensateur C mais à la capacité parasite formée par les enroulements de l'inductance L. De plus, la géométrie proposée repose sur un procédé de fabrication nécessitant plusieurs niveaux de métal et la mise en place de ponts qui, s'il est compatible avec les techniques de micro-fabrication conventionnelles, ne présente pas moins une certaine difficulté.

Le document "Quantum electromechanics of a hypersonic crystal", par Mahmoud Kalaee et al., daté du 3 septembre 2018, Arxiv.org, Cornell University Library, 201 Olin Library Cornell University Ithaca, NY14853, DOI 10.1038/S41565-019-0377-2, divulgue un exemple connu de dispositif de conversion électromécanique.

La présente invention se propose de répondre aux limites des systèmes de l'état de la technique brièvement introduit précédemment tant en termes de facilité de fabrication que de couplage électromécanique.

## RESUME DE L'INVENTION

L'invention offre une solution aux problèmes évoqués précédemment, en proposant de réaliser une inductance comprenant une piste électrique dont le matériau et la géométrie sont choisis de sorte à obtenir une forte inductance cinétique.

Un premier aspect de l'invention concerne un dispositif de conversion électromécanique comprenant :

- un circuit électrique résonant comportant une inductance ainsi qu'un condensateur, le condensateur ayant au moins une première électrode et une deuxième électrode ; et
- un oscillateur mécanique comportant au moins une micropoutrelle formée dans une membrane, les première et deuxième électrodes étant situées côte à côte et la première électrode du condensateur étant située sur une face de la micropoutrelle de sorte que la capacité électrique du condensateur varie lorsque l'oscillateur mécanique oscille ;

dispositif dans lequel l'inductance comporte une piste électrique de très faible épaisseur réalisée sur la membrane (la piste s'étend sur la surface de la membrane) dans un matériau supraconducteur choisi de sorte à obtenir une piste électrique ayant une forte inductance cinétique, trois fois supérieure à son inductance magnétique.

Grâce à l'invention, il n'est plus nécessaire de réaliser des enroulements pour obtenir l'inductance nécessaire. Cette dernière est en effet obtenue par l'utilisation d'une piste électrique dont le matériau et l'épaisseur ont été choisis de sorte à obtenir une forte inductance cinétique, qui s'ajoute à l'inductance magnétique usuelle. Une forte inductance peut ainsi être obtenue même en l'absence d'enroulement et même si la longueur totale de la piste reste modérée, ce qui permet d'obtenir la valeur d'inductance souhaitée tout en réduisant nettement les capacités parasites, augmentant ainsi le facteur couplage électro-mécanique $g_{em}^2$. De préférence, on entend par forte inductance cinétique une inductance cinétique par carré supérieure ou égale à 20 picohenry par carré, voire supérieure ou égale 50 picohenry (pH) par carré. Par inductance cinétique par carré, on entend l'inductance cinétique d'un tronçon de piste de forme carré (vu dessus). Ainsi, à titre d'exemple, une portion de piste dont la longueur est égale à 100 fois sa largeur aura une inductance cinétique égale à (ou tout au moins proche de) 100 fois son inductance cinétique par carré. A titre indicatif, pour une piste ayant une largeur comprise entre 50 et 500 nanomètres, l'inductance cinétique de la piste en question, par unité de longueur, peut être supérieure à 0,1 nH/$\mu$m, voire supérieure à 0,3 nH/$\mu$m ou même supérieure à 1 nH/$\mu$m.

Outre les caractéristiques qui viennent d'être évoquées dans le paragraphe précédent, le dispositif selon un premier aspect de l'invention peut présenter une ou plusieurs caractéristiques complémentaires parmi les suivantes, considérées individuellement ou selon toutes les combinaisons techniquement possibles.

Dans un mode de réalisation, la piste électrique a une inductance cinétique par carré supérieure ou égale à 20 picohenry par carré, voire supérieure ou égale 50 pH par carré.

Dans un mode de réalisation, le matériau supraconducteur de la piste électrique est choisi parmi le nitrure de titane (TiN), le nitrure de niobium (NbN) ou bien encore un matériau supraconducteur granulaire. Par matériau supraconducteur granulaire on entend par exemple un matériau formé de grains en matériau supraconducteur, ayant chacun une dimension typique (par exemple un diamètre) inférieur à 10 nm. Les grains en question peuvent en particulier être séparés les uns des autres par de minces couches d'un oxyde isolant (par exemple AlOx si le matériau est de l'Aluminium granulaire). Le nitrure de titane est particulièrement avantageux car il permet d'obtenir des couches très minces, ce qui, en plus de garantir une inductance cinétique élevée, permet d'assurer des bonnes propriétés mécaniques à l'oscillateur, la masse ajoutée par l'électrode au niveau de la micropoutrelle étant réduite au strict minimum.

Dans un mode de réalisation, l'épaisseur de la piste électrique est inférieure ou égale à 20 nm, voire inférieure ou égale à 10 nm ou même à 5 nm. Encore une fois, cela réduit la masse de la piste électrique sur la micropoutrelle tout en augmentant l'inductance cinétique de la piste électriques, avec tous les avantages décrits précédemment.

Dans un mode de réalisation, l'épaisseur de la piste électrique est inférieure ou égale à la longueur de London du matériau supraconducteur.

Dans un mode de réalisation, sur la majeure partie de sa longueur, voire sur toute sa longueur, la piste électrique ne comprend pas de parties s'étendant en vis-à-vis l'une de l'autre en étant séparées l'une de l'autre par un écart inférieur à 5 fois, voire 10 fois la largeur de la piste électrique à l'exception des parties formant les électrodes du condensateur à électrode(s) mobile(s). Une telle contrainte permet de limiter les capacités parasites au niveau de l'inductance.

Dans un mode de réalisation, la micropoutrelle de l'oscillateur mécanique est dite première micropoutrelle et l'oscillateur mécanique comprend une deuxième micropoutrelle et un troisième micropoutrelle, la première et la deuxième micropoutrelle étant reliées l'une à l'autre de sorte à former un diapason, la troisième micropoutrelle étant située entre les deux micropoutrelles du diapason, la deuxième électrode du condensateur étant formée sur la troisième micropoutrelle. Cette configuration présente l'avantage d'obtenir un mode de résonance équilibré : le facteur de qualité est plus élevé que la configuration à une seule micropoutrelle car le couplage avec les modes de vibrations externes est moindre. Par diapason on entend une structure mécanique à deux branches (à deux poutrelles) pouvant vibrer de manière équilibrée, c'est-à-dire sans déplacement du centre de masse de l'ensemble (ou tout au moins avec un déplacement minime de ce centre de masse). Cela peut être obtenu avec deux poutrelles symétriques l'une de l'autre d'un point de vue géométrique. Les deux poutrelles du diapason peuvent aussi être légèrement dissymétriques l'une de l'autre, mais avoir néanmoins la même masse, ou vibrer avec des amplitudes respectives différentes, mais telles que le centre de masse reste immobile.

On notera que, par électrode, on désigne de manière générale un élément en matériau conducteur (et en l'occurrence, ici, un élément gravé dans une couche mince de ce matériau conducteur).

Dans un mode de réalisation, une partie au moins de la piste électrique est formée sur un substrat de type « trap-rich ». Il peut s'agir d'un substrat « SOI » en silicium sur isolant (« Silicium On Insulator »), dans lequel la couche de silicium supérieure (« Si top »), et la couche d'isolant (en oxyde de silicium) qui la supporte ont été gravées de manière appropriée. En variante, le dispositif pourrait comprendre une couche supérieure en silicium (« Si top ») polycristallin obtenue par dépôt.

Dans un mode de réalisation, une partie au moins de la piste électrique est située sur une portion de la membrane qui est suspendue (la couche d'isolant du substrat SOI ayant été retirée, sous cette portion). Cela réduit les pertes électriques dans le circuit électrique résonnant.

Dans un mode de réalisation, l'oscillateur mécanique comprend un cadre séparé d'une partie principale de la membrane par des ouvertures pratiquées dans la membrane, la micropoutrelle étant raccordée au cadre et la deuxième électrode étant réalisée sur le cadre ou sur une autre micropoutrelle se raccordant au cadre, le cadre se raccordant à la partie principale de la membrane par un pont et par une ou plusieurs micropoutrelles de raccord, chaque micropoutrelle de raccord comprenant deux parties chacune plus longue que large et qui se raccordent l'une à l'autre en faisant en coude.

Dans un mode de réalisation, l'oscillateur mécanique est entouré par des isolateurs acoustiques formés dans ladite membrane, chaque isolateur comprenant plusieurs micropoutrelles parallèles les unes aux autres, la direction des micropoutrelles variant d'un isolateur à l'autre.

Un deuxième aspect de l'invention concerne un procédé de fabrication d'un un dispositif de conversion électromécanique tel que décrit ci-dessus, le procédé comprenant, à partir d'un substrat comportant une couche d'oxyde de silicium et une couche de silicium sur la couche d'oxyde de silicium :

- une étape de dépôt pleine plaque d'une couche de matériau supraconducteur destiné à former la piste électrique ; puis

- une première étape de lithographie de sorte à obtenir un motif définissant la membrane dans la couche de silicium, ledit motif définissant notamment ladite au moins une micropoutrelle de l'oscillateur mécanique ;

- une première étape de gravure de la couche de matériau supraconducteur et de la couche de silicium selon le motif défini lors de la première étape de lithographie ; puis

- une deuxième étape de lithographie de sorte à obtenir un motif définissant la piste électrique ;

- une deuxième étape de gravure de la couche de matériau supraconducteur selon le motif défini lors de la deuxième étape de lithographie de sorte à obtenir la piste électrique ;

- une troisième étape de gravure dans la couche d'oxyde de silicium de sorte à libérer la membrane de silicium définie précédemment.

Un troisième aspect de l'invention concerne un système quantique comprenant un dispositif de conversion selon le premier aspect de l'invention et un résonateur optique, le résonateur optique étant couplé (par couplage optomécanique) à l'oscillateur mécanique du dispositif de conversion.

Un quatrième aspect de l'invention concerne un système quantique comprenant un dispositif de conversion selon le premier aspect de l'invention et un qubit, ledit qubit étant couplé au dispositif de conversion.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

La [Fig. 1] montre une représentation schématique d'un dispositif de conversion.

La [Fig. 2] montre une représentation schématique du principe de fonctionnement de la conversion.

La [Fig. 3] montre un dispositif de conversion selon l'état de la technique.

La [Fig. 4] montre une représentation schématique d'un dispositif selon l'invention, vu de dessus.

La [Fig. 5A] montre une représentation schématique d'un oscillateur selon un mode de réalisation particulier de l'invention, vu de dessus.

La [Fig. 5B] montre une représentation schématique d'un oscillateur selon un autre mode de réalisation particulier de l'invention, vu de dessus.

La [Fig. 5C] montre une représentation schématique d'un oscillateur selon encore un autre mode de réalisation particulier de l'invention, vu de dessus.

La [Fig. 5D] montre une représentation schématique d'un oscillateur selon encore un autre mode de réalisation particulier de l'invention, vu de dessus.

La [Fig. 6] montre un dispositif selon l'invention dans lequel l'oscillateur mécanique est entouré d'isolateurs acoustiques, vu de dessus.

Les [Fig. 7A] à [Fig. 7E] illustre de manière schématique en vue de dessus l'oscillateur de la figue 4 à différentes étapes d'un procédé de fabrication selon l'invention.

## DESCRIPTION DETAILLEE

Les figures sont présentées à titre indicatif et nullement limitatif de l'invention.

Sauf précision contraire, un même élément apparaissant sur des figures différentes présente une référence unique.

### Dispositif de conversion électromécanique

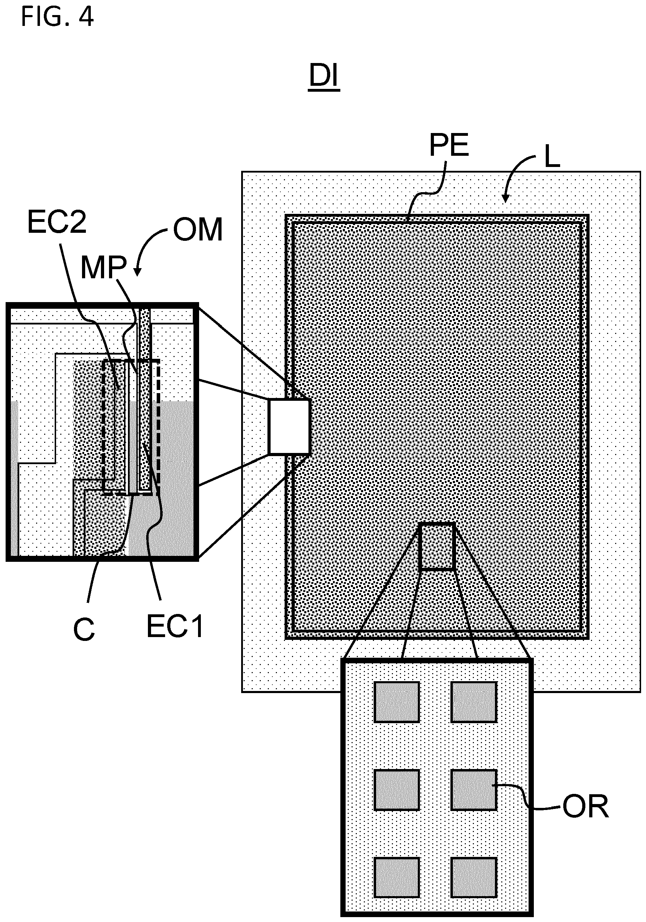

Un aspect de l'invention concerne un dispositif DI de conversion électromécanique. Comme illustré à la [Fig. 4], le dispositif DI selon l'invention comprend un circuit électrique résonant comportant une inductance L ainsi qu'un condensateur C ayant au moins une première électrode EC1 et une deuxième électrode EC2. Il comprend également un oscillateur mécanique OM comportant au moins une micropoutrelle MP formée dans une membrane (la membrane étant représentée par la zone en pointillés fins qui, dans l'exemple de la [Fig. 4], couvre l'essentiel de la surface du dispositif DI). Comme expliqué plus bas, la micropoutrelle est obtenue par gravure de la membrane (elle est en quelque sorte découpée dans la membrane). La micropoutrelle est ainsi formée par une (petite) portion de la membrane, qui se raccorde au reste de la membrane par l'une de ses deux extrémités, ou par ses deux extrémités, et avec, de part et d'autre de la micropoutrelle, des ouvertures ou fentes délimitant la micropoutrelle, pratiquées dans la membrane. Au niveau de la micropoutrelle, et plus généralement au niveau de l'oscillateur mécanique (et même sur la majeure partie de la surface du dipositif, ici), cette membrane est suspendue. Les première et deuxième électrodes EC1, EC2 sont situées côte à côte et l'une des électrodes EC1 du condensateur C est située sur une face, en l'occurrence une face supérieure de la micropoutrelle MP de sorte que la capacité électrique du condensateur C varie lorsque l'oscillateur mécanique OM (et donc la micropoutrelle MP) oscille. Les première et deuxième électrodes comprennent chacune une portion de piste réalisée à plat sur la membrane, ces deux portions de piste s'étendant parallèlement l'une à l'autre, à faible distance l'une de l'autre. L'un des bords de la première électrode EC1 s'étend en vis-à-vis de l'un des bords de la deuxième électrodes EC2, parallèlement à celui-ci, et à faible distance. Ces deux bords (et plus généralement les deux électrodes EC1 et EC2) s'écartent et se rapprochent l'un de l'autre lorsque la micropoutrelle oscille, oscillation qui a lieu principalement dans le plan de la membrane (déplacement/déformation parallèle à la membrane, pour obtenir un fort couplage électro-mécanique).

De plus, dans le dispositif DI selon l'invention l'inductance L comporte une piste électrique PE de très faible épaisseur réalisée sur ladite membrane dans un matériau supraconducteur choisi de sorte à obtenir une piste électrique PE à forte inductance cinétique.

Dans un mode de réalisation, on entend par forte inductance cinétique, une inductance cinétique par carré supérieure ou égale à 20 pH par carré, voire supérieure ou égale 50 pH par carré. A titre d'illustration, pour une piste ayant une largeur comprise entre 50 et 500 nm, l'inductance cinétique pourra être supérieure à $0{,}1nH/\mu m$, voire à $0{,}3$ $nH/\mu m$ ou même supérieure ou égale à $1nH/\mu m$.. L'inductance cinétique pourra par exemple être définie comme l'inductance totale de la piste électrique PE (ou de la portion de piste électrique considérée) moins l'inductance magnétique de la piste électrique PE. Par inductance magnétique on entend l'inductance due à la création d'un champ magnétique par la piste (à l'extérieur de la piste) lorsqu'elle est parcourue par un courant électrique. La valeur de l'inductance cinétique peut donc être déterminée par une mesure de l'inductance totale et un calcul (par exemple par éléments finis) de l'inductance magnétique (i.e. : de l'inductance « classique », usuelle), cette dernière étant entièrement déterminée par la géométrie de la piste électrique PE. Elle peut aussi être déterminée en comparant l'inductance de la piste mesurée à une température supérieure, puis à une température inférieure à une température critique du matériau supraconducteur formant la piste (température critique au-delà de laquelle le matériau n'est plus supraconducteur).

### Géométrie de l'inductance

Dans un mode de réalisation, illustré à la [Fig. 4], l'inductance est formée par une piste électrique PE suivant un parcours en forme de carré ou de rectangle à la surface de la membrane (sur cette figure, ainsi que sur les suivantes, cette piste est représentée par la zone en pointillés épais - tandis que les zones de « vide », c'est-à-dire les zones où la couche supérieure « Si top » ainsi que la couche isolante en SiO$_2$ ont été gravées, retirées, sont représentées en gris). Bien entendu, d'autres formes peuvent être envisagées, par exemple des formes en serpentin, avec des méandres pour gagner encore en compacité. Cependant, de préférence, la piste électrique PE formant l'inductance ne comprend pas de partie s'étendant en vis-à-vis l'une de l'autre en étant séparées par un écart inférieur à 5 fois, voire 10 fois la largeur de la piste électrique PE. En d'autres termes, cette piste électrique ne comprend pas de parties qui s'étendent en vis-à-vis l'une de l'autre et qui soient proches l'une de l'autre (afin d'éviter de créer des capacités parasites), sauf au niveau des électrodes du condensateur C en question, plus généralement, et au niveau de l'oscillateur mécanique (les parties de la piste électrique PE venant former les électrodes EC1, EC2 du condensateur C ne sont pas concernées par la contrainte en question).

Dans un mode de réalisation, le matériau supraconducteur est choisi parmi le nitrure de titane (TiN), le nitrure de niobium (NbN) ou bien encore un matériau supraconducteur granulaire. Le nitrure de titane est particulièrement avantageux car il permet d'obtenir des couches très minces (par exemple de 10nm d'épaisseur) tout en restant homogènes (avec des variations typiques d'épaisseur inférieures à 1nm). En pratique, des couches de TiN homogènes, ayant une épaisseur inférieure ou égale à 5 nm, et même inférieure ou égale à 3nm peuvent être obtenues. A titre d'exemple, pour une couche en TiN, une épaisseur comprise entre 5 et 10 nanomètres correspond à un bon compromis entre facilité de fabrication (et faible risque d'échec de la fabrication) d'une part, et obtention d'une forte inductance cinétique d'autre part. En plus de garantir une inductance cinétique élevée, réaliser la piste en question à partir d'une couche aussi mince permet d'assurer de bonnes propriétés mécaniques à l'oscillateur. En effet, la masse ajoutée par l'électrode au niveau de la micropoutrelle est réduite au strict minimum, ce qui permet notamment d'obtenir des fréquences de résonance mécanique relativement élevées et donc de relâcher les contraintes à respecter pour être dans les conditions dites de bandes résolues (bien connue du domaine, ces conditions ne seront pas rappelées ici). Par ailleurs, l'obtention de micropoutrelles plus légères permet de refroidir plus facilement l'oscillateur mécanique de sorte à l'amener dans un régime quantique, régime nécessaire lorsque le dispositif est employé pour réaliser un transfert de variable quantique d'un système électrique microonde vers un système mécanique (voire vers un système optique). De plus, en réduisant au minimum la quantité de métal ajoutée sur la micropoutrelle, on réduit d'autant les pertes mécaniques et autres effets dissipatifs susceptibles de se produire dans le métal, lors de sa déformation (déplacement de défauts par exemple). Des mesures réalisées sur un tel dispositif, avec une piste en TiN de 20 nm d'épaisseur montrent qu'une inductance cinétique de 20 pH/carré ou plus est alors obtenue. Et pour une piste en TiN, respectivement de 5 et de 3 nm d'épaisseur, une inductance cinétique de 100, et respectivement de 230 pH/carré est obtenue.

Dans un mode de réalisation, l'épaisseur de la piste électrique est inférieure ou égale à 20 nm, voire inférieure ou égale à 10 nm voire même inférieure ou égale à 5 nm. Dans un mode de réalisation, l'épaisseur de la piste électrique est inférieure ou égale à la longueur de London du matériau supraconducteur. Dans un mode de réalisation, la longueur de la piste électrique PE est inférieure ou égale à 0,5 mm. Quant à sa largeur, elle peut par exemple être comprise entre 50 et 500 nm, voire entre 100 et 300 nm (on pourra noter à ce sujet que la largeur de la piste n'est pas nécessairement constante tout au long de la piste).

Dans un mode de réalisation, la piste électrique PE a une inductance cinétique supérieure dix fois son inductance magnétique.

Dans un mode de réalisation, la piste électrique PE a une capacité parasite inférieure à deux fois la capacité du condensateur C et/ou inférieure à 2 femtofarad. La piste électrique en question peut en particulier avoir une inductance totale (magnétique+cinétique) supérieure à 50 nanohenry, voire supérieure à 100 nanohenry, tout en ayant une capacité parasite aussi faible que ce qui vient d'être indiqué.

*Géométrie de l'oscillateur mécanique.*

L'oscillateur mécanique OM peut adopter des géométries très diverses. Dans le mode de réalisation illustré à la [Fig. 4], ce dernier comprend une micropoutrelle MP sur laquelle est formée la première électrode EC1 du condensateur. La deuxième électrode EC2 située en regard de la micropoutrelle MP (et donc de la première électrode EC1) est quant à elle formée sur une structure beaucoup plus grande de sorte que les oscillations de l'oscillateur mécanique OM (oscillations qui causent une variation de la distance entre électrodes) sont principalement dues à la vibration de la micropoutrelle MP sur laquelle est formée la première électrode EC1. En d'autres termes, la première électrode EC1 est mobile tandis que la deuxième électrode est essentiellement fixe, ou tout au moins mobile à des fréquences bien différentes de la fréquence du mode de vibration considéré pour la micropoutrelle MP. Cependant, l'oscillateur peut également adopter d'autres géométries dans lesquelles les structures sur lesquelles sont formées la première électrode EC1 et la deuxième électrode EC2 sont toutes deux susceptibles d'osciller (première et deuxième électrodes mobiles).

On considère ici que le mode de vibration de l'oscillateur mécanique mentionné plus haut, pour lequel la micropoutrelle vibre principalement dans le plan de la membrane (et pour lequel $\omega_{\mu w} - \omega_{p1} = \omega_{opt} - \omega_{p2} = \omega_m$ ) a une fréquence $\omega_m$ (fréquence de résonnance) distincte des autres modes de vibration de l'oscillateur mécanique. A titre d'exemple, pour ces autres modes de vibration, l'écart entre la fréquence d'oscillation du mode en question et la fréquence

$\omega_m$ peut être supérieur à 5 fois la pleine largeur à mi-hauteur du pic de résonance à $\omega_m$. Toutefois, en variante, les pics de résonance respectifs de différents modes de vibration de l'oscillateur pourraient se superposer les uns aux autres.

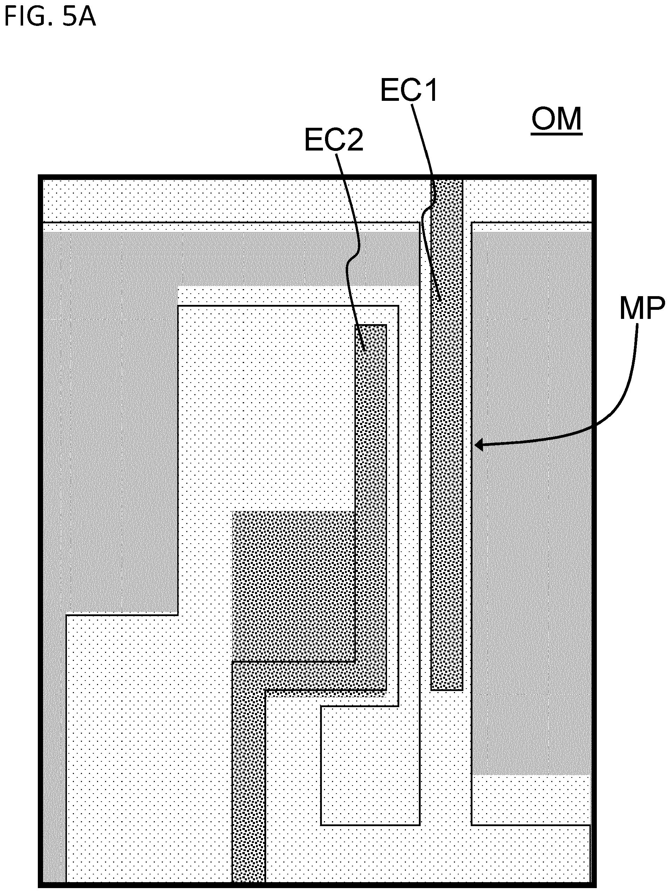

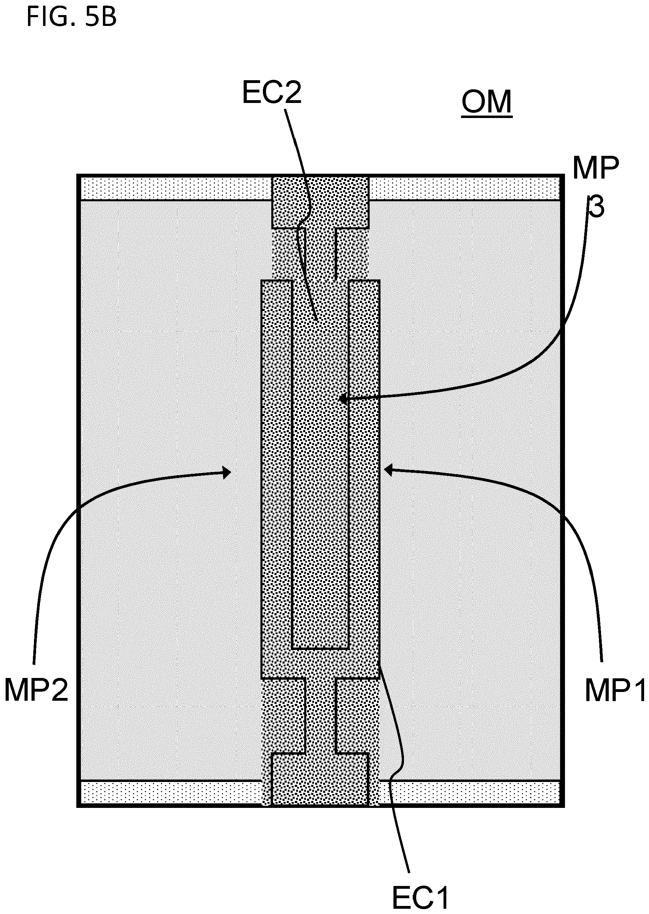

Dans un mode de réalisation illustré à la [Fig. 5A], la micropoutrelle MP de l'oscillateur mécanique OM est fixée au niveau de ces deux extrémités au lieu d'avoir une extrémité libre (micropoutrelle doublement encastrée), le reste de la structure étant identique à celle présentée à la [Fig. 4]. Sur la figure 5A, on a représenté la première électrode EC1 avec une largeur inférieure à celle de la micropoutrelle MP qui supporte l'électrode, pour la clarté de la figure, afin de pourvoir visualiser la micropoutrelle MP sous l'électrode EC1. Mais en pratique, la première électrode EC1 occupe généralement toute la largeur de la micropoutrelle (comme cela est représenté sur la [Fig. 5B]).

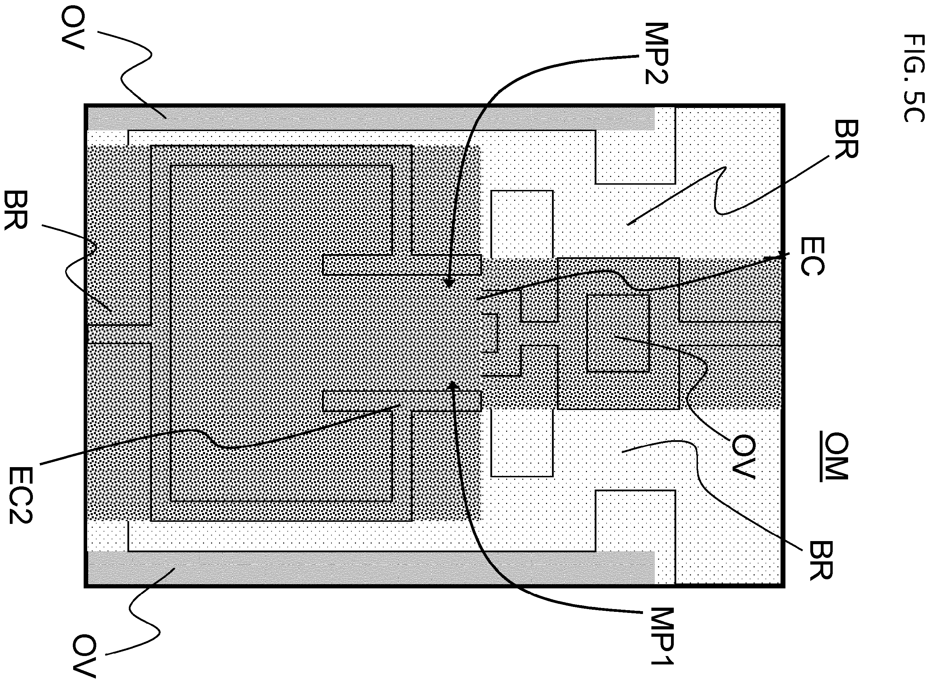

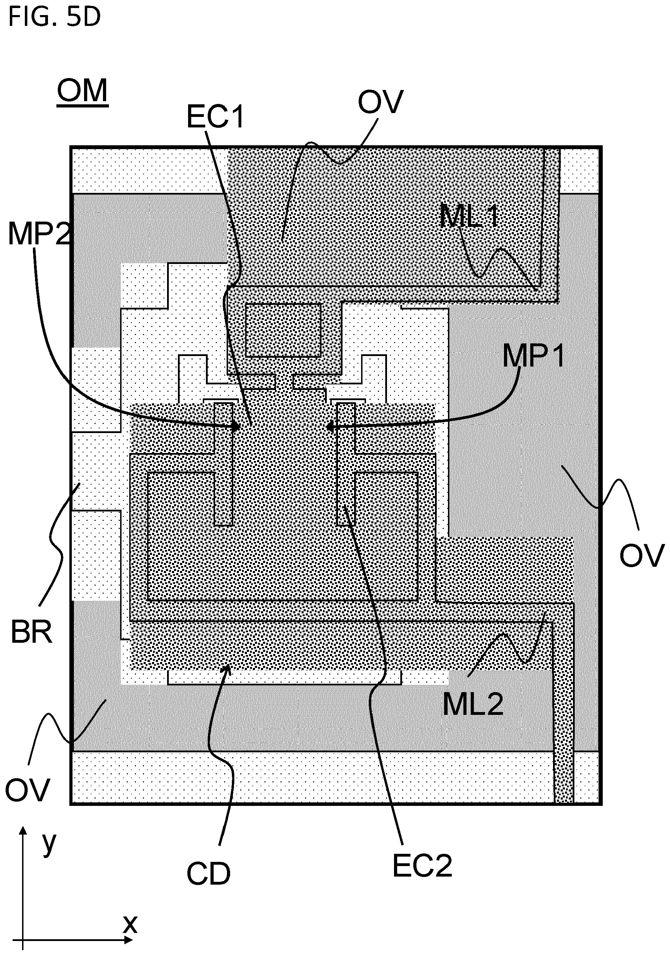

Dans un autre exemple de réalisation illustré à la [Fig. 5B], l'oscillateur mécanique OM comprend un diapason composé de deux micropoutrelles MP1, MP2 reliées entre elles au niveau de l'une de leur base, ainsi qu'une micropoutrelle MP3 située entre les deux micropoutrelles du diapason. Dans cette géométrie, la première électrode EC1 du condensateur est formée sur les deux micropoutrelles MP1, MP2 du diapason tandis que la deuxième électrode EC2 est formée sur la micropoutrelle MP3 qui s'étend entre les deux branches du diapason. On pourra noter que sur la [Fig. 5B], qui est une vue de dessus, les micropoutrelles MP1, MP2, MP3 ne sont pas visibles directement en elles-mêmes, car entièrement recouvertes par les électrodes (représentées en pointillé épais). D'ailleurs, sur les figures 5B, 5C et 5D, les zones en matériau supraconducteur (en pointillés épais) son toute réalisée sur une portion de la membrane (ici en silicium, représentée en pointillé fin), par exemple la micropoutrelle en question, même si la portion de membrane en question n'est pas visible sur la figure (car recouverte par le matériau en question).

Dans un autre exemple de réalisation illustré à la [Fig. 5C], l'oscillateur mécanique OM comprend un diapason composé de deux micropoutrelles MP1, MP2 reliées entre elles au niveau de l'une de leur base. Dans cette géométrie, la première électrode EC1 du condensateur est formée sur les deux micropoutrelle et la deuxième électrode EC2 comprend deux portions de piste, formées de part et d'autre du diapason (extérieurement au diapason). Le diapason se raccorde à un cadre, sur lequel est formée la deuxième électrode EC2, et qui est séparé d'une partie principale de la membrane par des ouvertures OV pratiquées dans cette membrane. Ce cadre, qui forme une sorte d'ilot, se raccorde à cette partie principale de la membrane seulement par des ponts BR, en l'occurrence au nombre de trois. Ici, ces ponts, formés chacun par une partie de la membrane, ont chacun une largeur inférieure à 10 fois, ou même à cinq fois la largeur de la micropoutrelle MP1 (soit par exemple une largeur de 1 micron tandis que la micropoutrelle MP1 a une largeur de 0,2 micron). Isoler ainsi ce cadre du reste de la membrane permet d'isoler l'oscillateur mécanique de modes de vibration externes, parasites.

Les exemples de réalisation des [Fig. 5B] et [Fig. 5C], à oscillateur en diapason, permettent d'obtenir des modes de résonance plus équilibrés qu'avec une unique micropoutrelle : le facteur de qualité s'en trouve plus élevé car le couplage avec les modes de vibration externes est moindre. Dans une variante de l'exemple de réalisation de la [Fig. 5C], les deux micropoutrelles MP1, MP2 qui portent la première électrode pourraient être reliées l'une à l'autre à leurs deux extrémités, formant ainsi un rectangle dont les deux côtés longs sont formés par les deux micropoutrelles MP1 et MP2 (chaque micropoutrelle étant alors fixée à ses deux extrémités).

Dans un autre exemple de réalisation illustré à la [Fig. 5D], comme dans le mode de réalisation précédent, l'oscillateur mécanique OM comprend un diapason composé de deux micropoutrelles MP1, MP2 reliées entre elles au niveau de l'une de leur base. Cet exemple de réalisation est semblable à de l'exemple de réalisation de la [Fig. 5C], mais au lieu d'être relié à la partie principale de la membrane par trois ponts, le cadre CD, qui supporte la deuxième électrode EC2 et auquel se raccorde le diapason, se raccorde à la partie principale de la membrane par un pont BR et par deux micropoutrelles de raccord ML1, ML2. Le pont a une forme rectangulaire et une largeur supérieure à cinq fois, ou même à dix fois la largeur de la micropoutrelle MP1. Les micropoutrelles de raccord ML1 et ML2 ont quant à elles une forme d'ensemble allongée et coudée : chaque micropoutrelle de raccord comprend deux parties chacune plus longue que large (et pas nécessairement rectilignes ; elles ont par exemple une largeur comprise entre 1 fois et 2 fois la largeur de la micropoutrelle MP1) et qui se raccordent l'une à l'autre en faisant en coude. Ainsi, elles forment entre elles un angle, ici un angle à 90 degrés. Cette configuration évite au maximum les reports de contrainte entre la partie principale de la membrane d'une part, et l'ilot (le cadre) qui sert de support à l'oscillateur mécanique OM d'autre part. Cette isolation mécanique permet de réduire différentes perturbations qui pourraient provenir du milieu extérieur, par exemple un changement de fréquence de résonance mécanique causé par une déformation d'ensemble du substrat ou de la membrane, notamment pour les poutres doublement encastrées. Dans l'exemple de la [Fig. 5D], pour chaque micropoutrelle de raccord ML1, ML2, les deux parties de la micropoutrelle s'étendent respectivement parallèlement à un axe x, et parallèlement à un axe y. La micropoutrelle de raccord a ainsi une raideur beaucoup plus faible que celle cadre CD, à la fois dans la direction x, et dans la direction y, permettant l'isolation mécanique en question. Ce mode de réalisation permet par ailleurs d'accroitre encore l'isolation de l'oscillateur mécanique relativement aux modes de vibration externes.

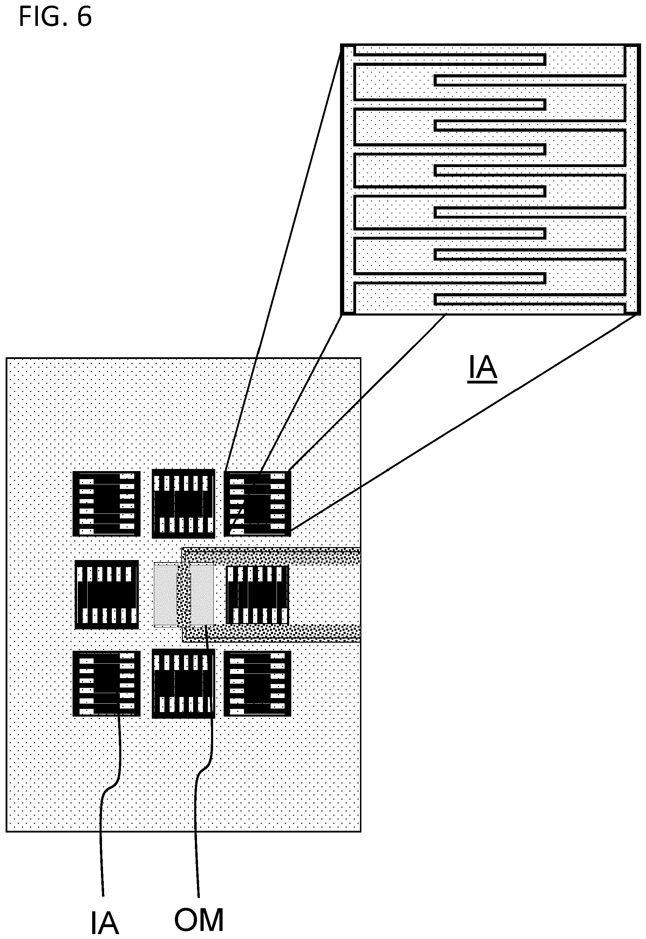

Dans un mode de réalisation illustré à la [Fig. 6], l'oscillateur mécanique est au moins partiellement entouré d'une pluralité d'isolateurs acoustiques IA. Ici, l'oscillateur mécanique est entouré d'isolateurs acoustiques sur toute sa périphérie. Chaque isolateur est formé dans la membrane en question (c'est-à-dire dans la partie supérieure en silicium, « Si top » du substrat SOI), par gravure. Il comprend plusieurs micropoutrelles parallèles les unes aux autres. Les micropoutrelles ont une ou des fréquences de vibration (fréquences propres, de résonnance) situées dans la même gamme que la fréquence de vibration $\omega_m$ de l'oscillateur mécanique (comprise par exemple entre 0,5 et 100 MHz). La direction des micropoutrelles varie d'un isolateur à l'autre. Ici, deux isolateurs adjacents ont plus précisément des poutrelles orientées à 90 degrés les unes des autres. Telle que représenté sur la [Fig. 6], le dispositif comprend une seule bande d'isolateurs entourant l'oscillateur mécanique (bande qui comporte 8 isolateurs). Ainsi, pour cet exemple, dans chaque direction du plan, l'oscillateur mécanique OM est séparé du reste de la membrane par un isolateur acoustique, mais non par deux. En variante, le dispositif pourrait néanmoins comprendre deux, ou plus de deux, bandes d'isolateurs, une première bande entourant l'oscillateur mécanique tandis qu'une deuxième bande entoure l'oscillateur ainsi que la première bande, et ainsi de suite. Dans ce cas, on pourra aussi prévoir une variation de la direction des micropoutrelles des isolateurs, d'un isolateur à l'autre (i.e. : entre deux isolateurs adjacents).

*Substrat supportant la membrane*

Dans un mode de réalisation, le dispositif est réalisé au moins en partie sur un substrat de type SOI. Dans un mode de réalisation, ce substrat SOI est de type « trap-rich ». Un tel substrat comprend une couche chargée de nombreux défauts cristallographiques situés entre la couche d'oxyde enterrée (ou BOX - bien connue de la personne du domaine) et le substrat HR-Si (dit substrat haute résistivité). En général, cette couche riche en défauts est réalisée en silicium polycristallin (polySi) ou en silicium amorphe ($\alpha$-Si). En l'absence d'une telle couche riche en défauts, les charges fixes présentes dans la couche d'oxyde enterrée attirent les charges présentes dans le substrat au niveau de l'interface créant une couche fine de conduction qui réduit la résistivité effective du substrat et entraine des pertes (effets de dissipation) pour un circuit électrique réalisé sur la couche supérieure en silicium, en particulier dans la gamme de fréquences micro-onde. Les défauts cristallins introduits piègent ces charges et permettent au substrat HR-Si de se comporter comme un substrat diélectrique sans perte, ce qui améliore le facteur de qualité du circuit électrique résonnant.

Dans un mode de réalisation, la membrane est au moins partiellement suspendue. Pour cela, comme illustré à la [Fig. 4], des orifices OR peuvent être aménagés dans la membrane afin de réaliser une gravure (un retrait) de la couche supportant la membrane, par exemple avec une gravure à l'acide fluorhydrique HF.

*Exemple de réalisation*

Dans un exemple de réalisation, la micropoutrelle est réalisée en silicium et à une longueur de 14 $\mu$m, une épaisseur de 0,1 $\mu$m (selon une direction perpendiculaire au substrat), une largeur de 0,2 $\mu$m et une densité de 2330kg/m$^3$. A partir du mode 0 de vibration en flexion (flexion en restant dans un plan parallèle au substrat, et avec les deux extrémités encastrées), il est possible de déterminer que la masse effective est de 6,524e$^{-16}$kg, que la fréquence associée à ce mode est de $\omega_m$ est de $2\pi \times 9,17$MHz et que l'amplitude de fluctuation quantique est de 37 fm (ces valeurs correspondent à une micropoutrelle sans la première électrode ; avec la première électrode, en TiN et d'une épaisseur de 5 nm, on s'écarte d'environ 10% de ces valeurs). Ces différentes informations permettent de déduire qu'il est possible d'obtenir, avec un dispositif selon l'invention, un facteur de couplage électromécanique supérieur d'un ordre de grandeur à ce qui est obtenu dans le dispositif de l'état de l'art (de G. Arnold et al.) présenté en introduction. En particulier, comme la capacité parasite de l'inductance est plus faible que dans l'art antérieur, on s'attend à un rendement $\eta$ proche de 1, ou tout au moins compris entre 0,25 et 0,9.

**Procédé de fabrication**

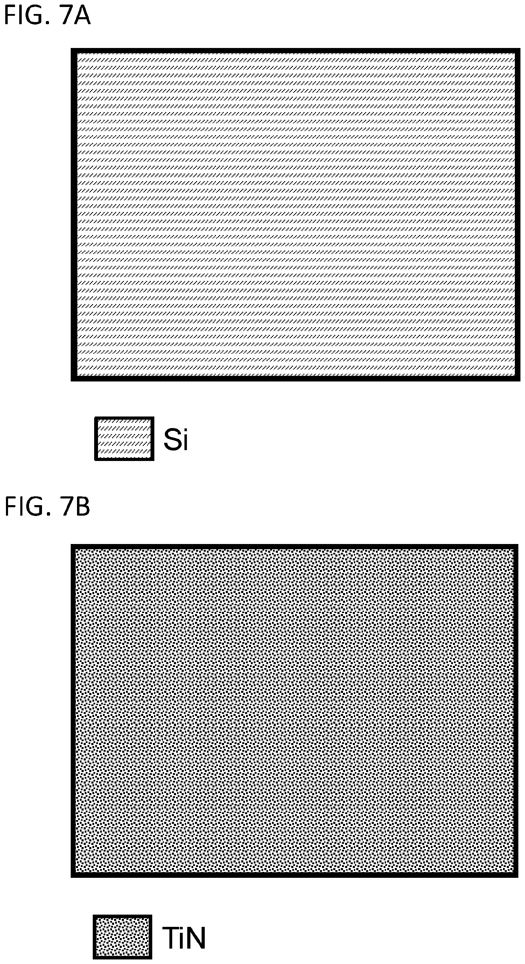

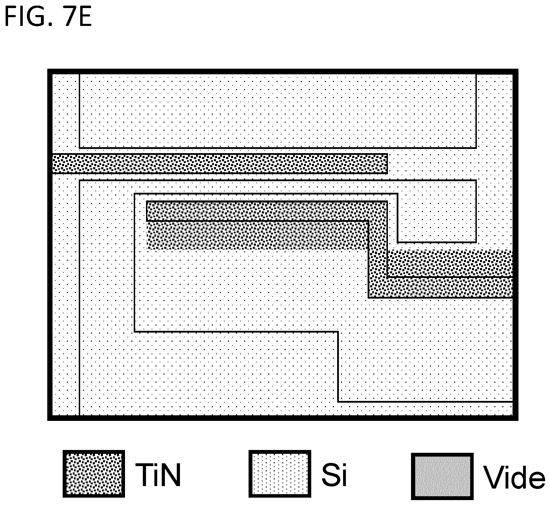

Afin d'obtenir un oscillateur mécanique tel que présenté précédemment, il est possible d'utiliser un substrat de type SOI comprenant une couche de silicium sur une couche d'oxyde de silicium. Pour cela, un deuxième aspect de l'invention illustré aux [Fig. 7A] à [Fig. 7E] concerne un procédé de fabrication d'un oscillateur mécanique OM destiné à un dispositif DI de conversion électromécanique.

A partir de ce substrat SOI (illustré à la [Fig. 7A] en vue de dessus), le procédé selon l'invention comprend une étape de dépôt pleine plaque d'une couche de matériau supraconducteur destinée à former la piste électrique. L'épaisseur déposée lors de cette étape est choisie de sorte à obtenir, à l'issue du procédé, une piste électrique à forte inductance cinétique. A l'issue de cette étape, comme illustré à la [Fig. 7B], le substrat est entièrement recouvert par la couche de matériau supraconducteur (du TiN dans cet exemple).

Le procédé comprend ensuite une première étape de lithographie de sorte à obtenir un motif définissant une membrane dans la couche de silicium. Le motif permet ainsi de définir les contours de la membrane sur laquelle sera réalisé le dispositif de conversion, notamment la ou les micropoutrelles MP, MP1, MP2, MP3, ainsi que des ouvertures OR dans cette membrane de sorte à faciliter sa libération lors d'une gravure ultérieure (c'est-à-dire lors du retrait d'une partie de la couche en oxyde de silicium).

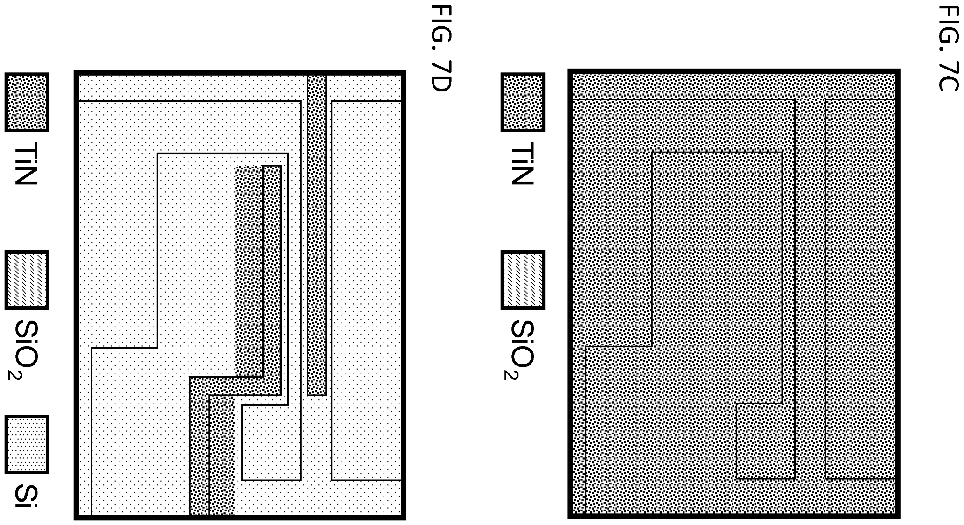

Le procédé comprend ensuite une première étape de gravure de la couche de matériau supraconducteur et de la couche de silicium selon le motif défini lors de la première étape de lithographie. Autrement dit, les motifs définis lors de la première étape de lithographie sont imprimés dans la couche de matériau supraconducteur et dans la couche de silicium. A l'issue de cette étape, comme illustré à la [Fig. 7C], les contours de la membrane (et donc de la ou des micropoutrelles) sont définis dans la couche de silicium et dans la couche de matériau supraconducteur. Il est intéressant de noter que la séparation entre les futures premières et deuxièmes électrodes est réalisée lors de cette étape. Autrement dit, il est possible de définir un espacement très faible sans pour autant imposer des contraintes d'alignement trop fortes lors de la réalisation de la piste électrique (contrainte d'alignement modérée pour le masque employé pour la gravure du reste de la piste, pas encore gravée à ce stade ; en particulier, un alignement très précis de ce masque avec la ou les micropoutrelles déjà gravées n'est pas indispensable, puisque la partie de piste située sur les micropoutrelles est gravée en même temps que les micropoutrelles). Cette astuce de fabrication facilite la cointégration d'une inductance en matériau supraconducteur (de dimensions globales importantes) et d'un micro-oscillateur mécanique (de dimensions nettement plus petites). On notera d'ailleurs que l'emploi de TiN pour la piste est propice à cette cointégration, car il résiste bien à l'acide fluorhudrique employé pour libérer la membrane suspendue.

Le procédé comprend ensuite une deuxième étape de lithographie de sorte à obtenir un motif définissant une piste électrique suivie d'une deuxième étape de gravure de la couche de matériau supraconducteur selon le motif défini lors de la deuxième étape de lithographie de sorte à obtenir la piste électrique. A l'issue de la deuxième étape de gravure, comme illustré à la [Fig. 7D], la piste électrique PE est formée sur la couche de silicium.

Enfin, afin de libérer la membrane de silicium, le procédé selon l'invention comprend une troisième étape de gravure dans la couche d'oxyde de silicium. A l'issue de cette étape, comme illustré à la [Fig. 7E], la membrane de silicium a été libérée, c'est-à-dire qu'une partie de la membrane se retrouve suspendue, grâce à ce retrait d'une partie de la couche en oxyde de silicium.

### Systèmes utilisant un dispositif de conversion électromécanique selon l'invention

Un troisième aspect de l'invention concerne un système quantique comprenant un dispositif DI de conversion selon un premier aspect de l'invention et un résonateur optique, avec un couplage opto-mécanique entre le résonateur optique et l'oscillateur mécanique du dispositif DI de conversion. En particulier, le champ électrique de fréquence optique confiné dans le résonateur optique (par exemple l'amplitude, ou la phase de ce champ) est couplé aux oscillations de l'oscillateur mécanique.

Un quatrième aspect de l'invention concerne un système quantique comprenant un dispositif DI de conversion selon un premier aspect de l'invention et un qubit, ledit qubit étant couplé au dispositif DI de conversion. Dans un mode de réalisation, le qubit est un qubit supraconducteur et ce dernier est couplé au dispositif DI selon l'invention au moyen d'une ligne électrique supraconductrice. Dans un mode de réalisation, le qubit est un qubit basé sur un centre NV (bien connu du domaine) présent dans un cristal de diamant de petite taille solidaire de la micropoutrelle MP de l'oscillateur mécanique OM du dispositif de conversion (un champ magnétique étant appliqué en outre au centre NV en question).

Les moyens de coupler un oscillateur optique ou un qubit à un oscillateur mécanique en général (également applicable à l'oscillateur du dispositif selon l'invention) ne seront pas détaillées ici par soucis de concision. Cependant, de tels moyens sont par exemple décrits dans le document de G. Arnold et al. cité en introduction du présent texte et illustré à la [Fig. 3].

### Revendications

1.   Dispositif (DI) de conversion électromécanique comprenant : un circuit électrique résonant comportant une inductance (L) ainsi qu'un condensateur (C), le condensateur (C) ayant au moins une première électrode (EC1) et une deuxième électrode (EC2) ; et un oscillateur mécanique (OM) comportant au moins une micropoutrelle (MP, MP1) formée dans une membrane, les première et deuxième électrodes (EC1, EC2) étant situées côte à côte et la première électrode (EC1) du condensateur (C) étant située sur une face de la micropoutrelle (MP, MP1) de sorte que la capacité électrique du condensateur (C) varie lorsque l'oscillateur mécanique (OM) oscille ; dispositif dans lequel l'inductance (L) comporte une piste électrique (PE) de très faible épaisseur réalisée sur la membrane dans un matériau supraconducteur choisi de sorte à obtenir une piste électrique (PE) ayant une forte inductance cinétique, trois fois supérieure à son inductance magnétique.

2.   Dispositif (DI) selon la revendication précédente dans lequel la piste électrique (PE) a une inductance cinétique par carré supérieure ou égale à 20 picohenry par carré voire supérieure ou égale à 50 picohenry par carré.

3.   Dispositif (DI) selon l'une des revendications précédentes dans lequel le matériau supraconducteur de la piste électrique (PE) est choisi parmi le nitrure de titane (TiN), le nitrure de niobium (NbN) ou bien encore un matériau supraconducteur granulaire.

4. Dispositif (DI) selon l'un des revendications précédentes dans lequel l'épaisseur de la piste électrique (PE) est inférieure ou égale à 20 nm.

5. Dispositif (DI) selon l'une des revendications précédentes dans lequel l'épaisseur de la piste électrique (PE) est inférieure ou égale à la longueur de London du matériau supraconducteur.

6. Dispositif (DI) selon l'une des revendications précédentes dans lequel, sur la majeure partie de sa longueur, la piste électrique (PE) ne comprend pas de parties s'étendant en vis-à-vis l'une de l'autre en étant séparées par un écart inférieur à 10 fois la largeur de la piste électrique (PE).

7. Dispositif (DI) selon l'une des revendications précédentes dans lequel la micropoutrelle (MP1) de l'oscillateur mécanique (OM) est dite première micropoutrelle (MP1) et dans lequel l'oscillateur mécanique (OM) comprend une deuxième micropoutrelle (MP2) et une troisième micropoutrelle (MP3), la première et la deuxième micropoutrelle étant reliées l'une à l'autre de sorte à former un diapason, la troisième micropoutrelle (MP3) étant située entre les deux micropoutrelles du diapason, la deuxième électrode (EC2) du condensateur étant formée sur la troisième micropoutrelle (MP3).

8. Dispositif (DI) selon l'une des revendications précédentes dans lequel une partie au moins de la piste électrique (PE) est formée sur un substrat SOI en silicium sur isolant de type « trap-rich ».

9. Dispositif (DI) selon l'une des revendications précédentes dans lequel une partie au moins de la piste électrique (PE) est située sur une portion de la membrane qui est suspendue.

10. Dispositif (DI) selon l'une des revendications précédentes dans lequel l'oscillateur mécanique (OM) comprend un cadre (CD) séparé d'une partie principale de la membrane par des ouvertures (OV) pratiquées dans la membrane, la micropoutrelle (MP1) étant raccordée au cadre (CD) et la deuxième électrode (EC2) étant réalisée sur le cadre ou sur une autre micropoutrelle se raccordant au cadre, le cadre se raccordant à la partie principale de la membrane par un pont (BR) et par une ou plusieurs micropoutrelles de raccord (ML1, ML2), chaque micropoutrelle de raccord (ML1, ML2) comprenant deux parties chacune plus longue que large et qui se raccordent l'une à l'autre en faisant en coude.

11. Dispositif (DI) selon l'une des revendications précédentes dans lequel l'oscillateur mécanique (OM) est entouré par des isolateurs acoustiques (IA) formés dans ladite membrane, chaque isolateur (IA) comprenant plusieurs micropoutrelles parallèles les unes aux autres, la direction des micropoutrelles variant d'un isolateur à l'autre.

12. Procédé de fabrication d'un dispositif (DI) de conversion électromécanique selon l'une quelconque des revendications précédentes, le procédé comprenant, à partir d'un substrat comportant une couche d'oxyde de silicium et une couche de silicium sur la couche d'oxyde de silicium :

- une étape de dépôt pleine plaque d'une couche de matériau supraconducteur destiné à former la piste électrique (PE) ; puis
- une première étape de lithographie de sorte à obtenir un motif définissant la membrane dans la couche de silicium, ledit motif définissant notamment ladite au moins une micropoutrelle (MP, MP1) de l'oscillateur mécanique (OM) ;
- une première étape de gravure de la couche de matériau supraconducteur et de la couche de silicium selon le motif défini lors de la première étape de lithographie ; puis
- une deuxième étape de lithographie de sorte à obtenir un motif définissant la piste électrique (PE) ;
- une deuxième étape de gravure de la couche de matériau supraconducteur selon le motif défini lors de la deuxième étape de lithographie de sorte à obtenir la piste électrique ;
- une troisième étape de gravure dans la couche d'oxyde de silicium de sorte à libérer la membrane de silicium définie précédemment.

13. Système quantique comprenant un dispositif (DI) de conversion selon l'une des revendications 1 à 11 et un résonateur optique, ledit résonateur optique étant couplé à l'oscillateur mécanique (OM) du dispositif (DI) de conversion.

**14.** Système quantique comprenant un dispositif (DI) de conversion selon l'une des revendications 1 à 11 et un qubit, ledit qubit étant couplé au dispositif (DI) de conversion.

**Patentansprüche**

**1.** Vorrichtung (DI) zur elektromechanischen Umwandlung, umfassend: einen elektrischen Resonanzkreis mit einer Induktivität (L) sowie einem Kondensator (C), wobei der Kondensator (C) mindestens eine erste Elektrode (EC1) und eine zweite Elektrode (EC2) aufweist; und einen mechanischen Oszillator (OM) mit mindestens einem Mikroträger (MP, MP1), der in einer Membran ausgebildet ist, wobei die erste und die zweite Elektrode (EC1, EC2) Seite an Seite angeordnet sind und die erste Elektrode (EC1) des Kondensators (C) auf einer Seite des Mikroträgers (MP, MP1) angeordnet ist, so dass sich die elektrische Kapazität des Kondensators (C) ändert, wenn der mechanische Oszillator (OM) schwingt; Vorrichtung, bei der die Induktivität (L) eine elektrische Leiterbahn (PE) mit sehr geringer Dicke umfasst, die auf der Membran aus einem supraleitenden Material hergestellt ist, das so gewählt ist, dass eine elektrische Leiterbahn (PE) mit einer hohen kinetischen Induktivität erhalten wird, die dreimal größer ist als ihre magnetische Induktivität.

**2.** Vorrichtung (DI) nach vorhergehendem Anspruch, bei der die elektrische Leiterbahn (PE) eine kinetische Induktivität pro Quadrat von größer oder gleich 20 Picohenry pro Quadrat oder sogar größer oder gleich 50 Picohenry pro Quadrat hat.

**3.** Vorrichtung (DI) nach einem der vorhergehenden Ansprüche, bei der das supraleitende Material der elektrischen Leiterbahn (PE) aus Titannitrid (TiN), Niobnitrid (NbN) oder auch einem granularen supraleitenden Material ausgewählt ist.

**4.** Vorrichtung (DI) nach einem der vorhergehenden Ansprüche, bei der die Dicke der elektrischen Leiterbahn (PE) kleiner oder gleich 20 nm ist.

**5.** Vorrichtung (DI) nach einem der vorhergehenden Ansprüche, bei der die Dicke der elektrischen Leiterbahn (PE) kleiner oder gleich der London-Länge des supraleitenden Materials ist.

**6.** Vorrichtung (DI) nach einem der vorhergehenden Ansprüche, bei der die elektrische Leiterbahn (PE) über den größten Teil ihrer Länge keine Abschnitte umfasst, die sich einander gegenüberliegend erstrecken und durch einen Abstand getrennt sind, der kleiner als das 10-fache der Breite der elektrischen Leiterbahn (PE) ist.

**7.** Vorrichtung (DI) nach einem der vorhergehenden Ansprüche, bei der der Mikroträger (MP1) des mechanischen Oszillators (OM) als erster Mikroträger (MP1) bezeichnet wird und bei der der mechanische Oszillator (OM) einen zweiten Mikroträger (MP2) und einen dritten Mikroträger (MP3) umfasst, wobei der erste und der zweite Mikroträger so miteinander verbunden sind, dass sie eine Stimmgabel bilden, wobei der dritte Mikroträger (MP3) zwischen den beiden Mikroträgern der Stimmgabel angeordnet ist und die zweite Elektrode (EC2) des Kondensators auf dem dritten Mikroträger (MP3) ausgebildet ist.

**8.** Vorrichtung (DI) nach einem der vorhergehenden Ansprüche, bei der zumindest ein Teil der elektrischen Leiterbahn (PE) auf einem SOI-Substrat (Silizium auf einem Isolator) vom Typ "Trap-Rich" ausgebildet ist.

**9.** Vorrichtung (DI) nach einem der vorhergehenden Ansprüche, bei der sich zumindest ein Teil der elektrischen Leiterbahn (PE) auf einem Abschnitt der Membran befindet, der aufgehängt ist.

**10.** Vorrichtung (DI) nach einem der vorhergehenden Ansprüche, bei der der mechanische Oszillator (OM) einen Rahmen (CD) umfasst, der von einem Hauptteil der Membran durch Öffnungen (OV) in der Membran getrennt ist, wobei der Mikroträger (MP1) mit dem Rahmen (CD) verbunden ist und die zweite Elektrode (EC2) auf dem Rahmen oder auf einem anderen Mikroträger, der sich an den Rahmen anschließt, ausgebildet ist, wobei der Rahmen mit dem Hauptteil der Membran über eine Brücke (BR) und über einen oder mehrere Mikro-Verbindungsträger (ML1, ML2) verbunden ist, wobei jeder Mikro-Verbindungsträger (ML1, ML2) zwei Teile umfasst, die jeweils länger als breit sind und die sich in einem Bogen aneinander anschließen.

**11.** Vorrichtung (DI) nach einem der vorhergehenden Ansprüche, bei der der mechanische Oszillator (OM) von akustischen Isolatoren (IA) umgeben ist, die in der Membran ausgebildet sind, wobei jeder Isolator (IA) mehrere Mikro-

**EP 4 079 680 B1**

träger umfasst, die parallel zueinander verlaufen, wobei die Richtung der Mikroträger von einem Isolator zum anderen variiert.

12. Verfahren zur Herstellung einer elektromechanischen Umwandlungsvorrichtung (DI) nach einem der vorhergehenden Ansprüche, wobei das Verfahren ausgehend von einem Substrat mit einer Siliziumoxidschicht und einer Siliziumschicht auf der Siliziumoxidschicht folgendes umfasst:

- einen Schritt des Aufbringens einer Schicht aus vollflächigem supraleitenden Material zur Bildung der elektrischen Leiterbahn (PE); dann
- einen ersten Lithographieschritt, um ein Muster zu erhalten, das die Membran in der Siliziumschicht definiert, wobei das Muster insbesondere den mindestens einen Mikroträger (MP, MP1) des mechanischen Oszillators (OM) definiert;
- einen ersten Schritt des Ätzens der Schicht aus supraleitendem Material und der Siliziumschicht gemäß dem im ersten Lithographieschritt festgelegten Muster; und dann
- einen zweiten Lithographieschritt, um ein Muster zu erhalten, das die elektrische Leiterbahn (PE) definiert;
- einen zweiten Schritt des Ätzens der Schicht aus supraleitendem Material gemäß dem im zweiten Lithographieschritt festgelegten Muster, um die elektrische Leiterbahn zu erhalten;
- einen dritten Schritt des Ätzens in der Siliziumoxidschicht, um die zuvor definierte Siliziummembran freizusetzen.

13. Quantensystem mit einer Umwandlungsvorrichtung (DI) nach einem der Ansprüche 1 bis 11 und einem optischen Resonator, wobei der optische Resonator mit dem mechanischen Oszillator (OM) der Umwandlungsvorrichtung (DI) gekoppelt ist.

14. Quantensystem mit einer Umwandlungsvorrichtung (DI) nach einem der Ansprüche 1 bis 11 und einem Qubit, wobei das Qubit mit der Umwandlungsvorrichtung (DI) gekoppelt ist.

**Claims**

1. Electromechanical conversion device (DI) comprising: a resonant electrical circuit comprising an inductance (L) and a capacitor (C), the capacitor (C) having at least a first electrode (EC1) and a second electrode (EC2); and a mechanical oscillator (OM) comprising at least one microbeam (MP, MP1) formed in a membrane, the first and second electrodes (EC1, EC2) being located side by side and the first electrode (EC1) of the capacitor (C) being located on a face of the microbeam (MP, MP1) in such a way that the electrical capacitance of the capacitor (C) varies when the mechanical oscillator (OM) oscillates; device wherein the inductance (L) comprises an electric track (PE) of very low thickness made on the membrane and made of a superconductive material chosen in such a way as to obtain an electric track (PE) having a high kinetic inductance, three times greater than its magnetic inductance.

2. Device (DI) according to the preceding claim wherein the electric track (PE) has a kinetic inductance per square greater than or equal to 20 picohenry per square, or even greater than or equal to 50 picohenry per square.

3. Device (DI) according to one of the preceding claims wherein the superconductive material of the electric track (PE) is chosen from titanium nitride (TiN), niobium nitride (NbN) or a granular superconductive material.

4. Device (DI) according to one of the preceding claims wherein the thickness of the electric track (PE) is less than or equal to 20 nm.

5. Device (DI) according to one of the preceding claims wherein the thickness of the electric track (PE) is less than or equal to the London's length of the superconductive material.

6. Device (DI) according to one of the preceding claims wherein, over most of its length, the electric track (PE) does not comprise portions extending facing one another while being separated by a distance less than 10 times the width of the electric track (PE).

7. Device (DI) according to one of the preceding claims wherein the microbeam (MP1) of the mechanical oscillator (OM) is referred to as first microbeam (MP1) and wherein the mechanical oscillator (OM) comprises a second microbeam (MP2) and a third microbeam (MP3), the first and the second microbeam being connected to one another in such a way as to form a diapason, the third microbeam (MP3) being located between the two microbeams of the diapason, the second electrode (EC2) of the capacitor being formed on the third microbeam (MP3).

8. Device (DI) according to one of the preceding claims wherein at least a portion of the electric track (PE) is formed on a silicon-on-insulator (SOI) substrate of the "trap-rich" type.

9. Device (DI) according to one of the preceding claims wherein at least a portion of the electric track (PE) is located on a portion of the membrane that is suspended.

10. Device (DI) according to one of the preceding claims wherein the mechanical oscillator (OM) comprises a frame (CD) separated from a main portion of the membrane by openings (OV) made in the membrane, the microbeam (MP1) being connected to the frame (CD) and the second electrode (EC2) being carried out on the frame or on another microbeam that is connected to the frame, the frame connecting to the main portion of the membrane by a bridge (BR) and by one or more connector microbeams (ML1, ML2), each connector microbeam (ML1, ML2) comprising two portions each longer than wide and which are connected to one another by making a bend.

11. Device (DI) according to one of the preceding claims wherein the mechanical oscillator (OM) is surrounded by acoustic insulators (IA) formed in said membrane, each insulator (IA) comprising several microbeams parallel to one another, with the direction of the microbeams varying from one insulator to the other.

12. Method for manufacturing an electromechanical conversion device (DI) according to any of the preceding claims, the method comprising, from a substrate comprising a silicon oxide layer and a silicon layer on the silicon oxide layer:

  - a step of full-plate deposition of a layer of superconductive material intended to form the electric track (PE); then
  - a first step of lithography in such a way as to obtain a pattern defining the membrane in the silicon layer, the pattern defining, inter alia, said at least one microbeam (MP, MP1) of the mechanical oscillator (OM) ;
  - a first step of etching the layer of superconductive material and of the layer of silicon according to the pattern defined during the first step of lithography; then
  - a second step of lithography in such a way as to obtain a pattern defining the electric track (PE);
  - a second step of etching the layer of superconductive material according to the pattern defined during the second step of lithography in such a way as to obtain the electric track;
  - a third step of etching in the silicon oxide layer in such a way as to release the silicon membrane defined hereinabove.

13. Quantum system comprising a conversion device (DI) according to one of claims 1 to 11 and an optical resonator, said optical resonator being coupled to the mechanical oscillator (OM) of the conversion device (DI).

14. Quantum system comprising a conversion device (DI) according to one of claims 1 to 11 and a qubit, said qubit being coupled to the conversion device (DI).

FIG. 1

CO

CR

MB

C

L

7GHz

192THz

FIG. 2

FIG. 3

FIG. 4

FIG. 5A

FIG. 5B

EC2          OM

MP
3

MP2          MP1

EC1

FIG. 5C

FIG. 5D

FIG. 6

IA

IA    OM

FIG. 7A

Si

FIG. 7B

TiN

FIG. 7C

TiN          SiO$_2$

FIG. 7D

TiN          SiO$_2$          Si

FIG. 7E

| TiN | Si | Vide |

## RÉFÉRENCES CITÉES DANS LA DESCRIPTION

**Littérature non-brevet citée dans la description**

- **G. ARNOLD et al.** Converting microwave and telecom photons with a silicon photonic nanomechanical interface. *Nature Com.,* 2020, vol. 11 (4460

- Quantum electromechanics of a hypersonic crystal. **MAHMOUD KALAEE et al.** Arxiv.org. Cornell University Library, 03 Septembre 2018